# EUROPEAN PATENT SPECIFICATION

(11) **EP 3 032 591 B1**
(45) Date of publication and mention of the grant of the patent: **23.10.2019**
(21) Application number: 15183256.5
(22) Date of filing: 01.09.2015
(51) Int. Cl.: H01L 31/049

(54) **SOLAR CELL MODULE**
SOLARZELLENMODUL
MODULE DE CELLULES SOLAIRES

(30) Priority: 08.12.2014 KR 20140175173
(43) Date of publication of application: 15.06.2016
(73) Proprietor: LSIS Co., Ltd., Anyang-si, Gyeonggi-do 431-848 (KR)
(72) Inventor: WON, Chang Sub, Anyang-si, Gyeonggi-do 431-848 (KR); KIM, Dong Chan, Anyang-si, Gyeonggi-do 431-848 (KR)
(74) Representative: K&L Gates LLP

(56) References cited:
- KR-A- 20140 082 580
- US-A1- 2010 108 128
- US-A1- 2014 041 716

## Description

### BACKGROUND OF THE INVENTION

### 1. Field of the Invention

The present disclosure relates to a solar cell module, and more particularly, to a solar cell moduie in which contraction of a back sheet caused as the solar cell module is used for a long period of time is prevented and adhesion between an encapsulant and the back sheet is enhanced, and which has a stable structure.

### 2. Background of the Invention

Recently, solar batteries have been developed as a next-generation environmentally friendly energy source and rapidly become prevalent to be used in houses and for the purposes of industrial purposes.

A solar battery is formed by modularizing a plurality of solar cells.

Here, a plurality of solar cells are fixedly packed in an encapsulation layer, and a back sheet is bonded as a sealing member to a lower surface of the encapsulation layer, so as to be modularized.

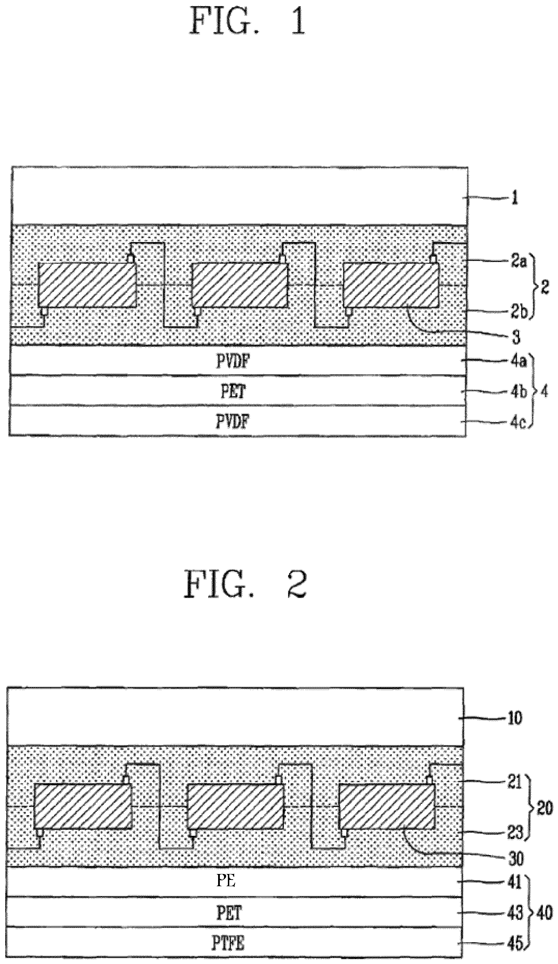

FIG. 1 is a cross-sectional view of a related art general solar cell module.

As illustrated in FIG. 1, the related art solar cell module is formed by sequentially stacking a transparent tempered glass 1, an upper encapsulant 2a, a plurality of solar cells 3, a lower encapsulant 2b, and a back sheet 4.

The plurality of solar cells 3 are fixedly packed between the upper encapsulant 2a and the lower encapsulant 2b. Here, as a material of the encapsulants 2, an ethylene vinyl acetate (EVA) is largely used in order to firmly fix the solar cell 3 therein.

The back sheet 4 is attached to a lower surface of the lower encapsulant 2b to block an introduction of moisture or oxygen degrading an output amount to thus prevent lowering of the output amount when the solar cell module is in use for a long period of time, and prevent degradation due to ultraviolet rays as well.

Meanwhile, recently, due to an increase in cost of solar cell modules, low-priced back sheets are urgently required.

For this reason, back sheets used in solar cell modules need be formed of a material having properties such as heat resistance or durability sufficiently enduring high temperatures and humidity and ultraviolet rays to prevent a degradation of an output amount of solar cell modules and need to be low in price.

In general, the back sheet used in the solar cell module is formed by stacking a polyethylene terephthalate (PET) film 4b, a base substrate, having heat resistance, or the like, and fluorine-based films 4a and 4c having weather resistance.

That is, the back sheet 4 includes the PET film 4b as a base substrate and the fluorine-based films 4a and 4c bonded to the PET film 4b through an adhesive, and since the PET film 4b has excellent heat resistance and durability, it is largely used as a base substrate of the back sheet 1.

Also, as the fluorine-based films 4a and 4c, a polyvinylidenflouride (PVDF) film or a polyvinyl fluoride (PVF) film is largely used, and these fluorine-based films 4a and 4c have excellent durability.

Regarding the back sheet used in the solar cell module configured as described above, Korean patent Registration No. 10-1349734 discloses a back sheet for a solar cell module including polyethylene, polyester, and fluorine-coated layers.

However, in the registered technique, when the solar cell module is in use for a long period of time, a back sheet contracts to deform an external shape of the solar cell module and adhesion strength between the encapsulant and the back sheet is reduced to separate the encapsulant and the back sheet, resulting in a significant degradation of structural stability of the solar cell module. US 2014/041716 A1 (KANG HAN JUN [KR] ET AL) 13 February 2014 (2014-02-13) discloses a back sheet for a solar cell module and a solar cell module including the same, wherein the solar cell module comprises a polyester film layer and a fluorine coating layer which coats at least one surface of the polyester film layer. A surface layer of the back sheet is formed on an upper surface of the polyester film layer, and includes a polyethylene film layer attached to an ethylene vinyl acetate (EVA) sheet of the solar cell.

US 2010/108128 A1 (CHU LIH-LONG [US] ET AL) 6 May 2010 (2010-05-06) discloses co-extruded, multilayered polyolefin-based back sheet for electronic device modules.

### SUMMARY OF THE INVENTION

Therefore, an aspect of the detailed description is to provide solar cell module in which contraction of a back sheet caused as the solar cell module is used for a long period of time is prevented and adhesion between an encapsulant and the back sheet is enhanced, and which has a stable structure. The present invention is defined by the features of the independent claim. Preferred beneficial embodiments thereof are defined by the sub-features of the dependent claims.

To achieve these and other advantages and in accordance with the purpose of this specification, as embodied and broadly described herein, a solar cell module includes: a transparent member; an encapsulant allowing the transparent member to be bonded to an upper surface thereof; a plurality of solar cells fixed within the encapsulant; and a back sheet bonded to a lower surface of the encapsulant, wherein the back sheet includes a substrate; a polytetrafluoroethylene film layer formed on a lower surface of the substrate; and a surface layer formed on an upper surface of the substrate and formed of polyethylene, as defined in claim 1.

The encapsulant may be formed as a polyolefin-based encapsulant.

The encapsulant may include an ethylene vinyl acetate-based encapsulant provided to cover upper portions of the plurality of solar cells, a polyolefin-based encapsulant provided to cover lower portions of the plurality of solar cells, and the surface layer may be bonded to the polyolefin-based encapsulant.

The substrate may be a polyethyleneterephthalate film layer.

As described above, according to the solar cell module of the present invention, since the polyethylene (PE) film is used to form the surface layer of the back sheet, even though the solar cell module is used for a long period of time, contraction of the back sheet is prevented, and thus, the solar cell module may be prevented from being deformed in an outer appearance thereof due to contraction of the back sheet.

In addition, since contraction of the back sheet is prevented, adhesion between the encapsulant and the back sheet in which solar cells are fixed may be strengthened.

In addition, since the solar cell module is prevented from being deformed in an outer appearance thereof, the solar cell module may have a stable structure.

Further scope of applicability of the present application will become more apparent from the detailed description given hereinafter.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a schematic cross-sectional view illustrating a related art solar cell module.
FIG. 2 is a schematic cross-sectional view illustrating a solar cell module according to an embodiment of the present invention.

### DETAILED DESCRIPTION OF THE INVENTION

Description will now be given in detail of the exemplary embodiments, with reference to the accompanying drawings. For the sake of brief description with reference to the drawings, the same or equivalent components will be provided with the same reference numbers, and description thereof will not be repeated.

Hereinafter, a solar cell module according to an embodiment of the present invention will be described in detail with reference to the accompanying drawings.

FIG. 2 is a schematic cross-sectional view illustrating a solar cell module according to an embodiment of the present invention.

As illustrated in FIG. 2, in general, the solar cell module is completed through a process of sequentially stacking a transparent member 10, an upper encapsulant 21, solar cells 30, a lower encapsulant 23, and a back sheet 40, and subsequently modularizing the resultant structure in order of performing exhausting on the resultant structure in a vacuum laminator for four minutes, pressing the resultant structure for one minute, and maintaining the resultant structure for 10 minutes.

The transparent member 10 is formed of transparent tempered glass, or the like, and protect an upper portion of the solar cell 30.

The encapsulants 21 and 23 fixedly pack a plurality of solar cells 30, and the back sheet 40 is bonded to a lower portion of the solar cells 30 to protect the solar cells 30 such that the solar cells 30 may be used for a long period of time.

Meanwhile, the back sheet 40 used in the solar cell module includes a substrate 43, a PTFE layer 45 formed on a lower surface of the substrate 43, and a surface layer 41.

The substrate 43 is formed of various materials having bearing power, heat resistance, barrier properties (moisture barrier properties), and heat dissipation properties, and serves as a support of the back sheet 40.

In an embodiment of the present invention, the substrate 43 is formed as a polyethylene terephthalate (PET) film layer to have enhanced bearing power and heat resistance, and here, the PET film layer may be formed of a sheet of film or may be formed by stacking two or more film layers and laminating the film layers.

Also, a material used to form the substrate 43 is not limited to the PET film layer and the substrate 43 may be formed of various synthetic resin materials.

For example, the substrate 43 may be formed of polytetrafluoroethylene (PTFE), polybutyleneterephthalate (PBT), polyethylenenaphthalate (PEN), or polybutylenenaphthalate (PBN), and here, the substrate 43 may be formed by selecting one or more of these materials.

Also, a thickness of the PET film layer is not particularly limited. However, if the thickness of the PET film layer is less than 50 *µ*m, barrier properties, heat resistance, mechanical strength, and dimensional stability are degraded, and when the thickness of the PET film layer exceeds 1000 *µ*m, flexibility may be degraded and production cost may increase.

Thus, preferably, the thickness of the PET film layer ranges from 50 *µ*m to 1000 *µ*m.

The surface layer 41 is formed on an upper surface of the substrate 43 and is in contact with the encapsulant 20 forming the solar cell module.

Here, the encapsulant 20 includes an upper encapsulant 21 and a lower encapsulant 23, and the upper encapsulant 21 and the lower encapsulant 23 are formed as polyolefin-based encapsulants.

Also, the upper encapsulant 21 may be formed as an ethylenevinylacetate (EVA) encapsulant, and the lower encapsulant 23 may be formed as a polyolefin-based encapsulant.

Thus, when the back sheet 40 used in the solar cell module is bonded to the encapsulant 20, the surface layer 41 of the back sheet 40 is bonded to the polyolefin-based encapsulant forming the lower encapsulant 23.

According to the present invention, since the polyethylene (PE) film is used to form the surface layer 41, even though the solar battery is used for a long period of time, the back sheet 40 does not contract, and thus, the overall shape of the solar cell module is prevented from being deformed.

Also, since contraction of the back sheet 40 is prevented, adhesion between the encapsulant 20 and the back sheet 40 is strengthened.

Meanwhile, the surface layer 41 contains white inorganic substance, and tensile strength and dimensional stability of the back sheet 40 are enhanced through the white inorganic substance, and light of the sun incident onto the back sheet 40 is reflected toward the solar cell 30 to increase an amount of light received by the solar cell 30.

A thickness of the surface layer 41 ranges from 5 *µ*m to 30 *µ*m to enhance an effect such as weather resistance, or the like.

Meanwhile, a polytetrafluoroethylene (PTFE) film layer 45 is formed on a lower surface of the substrate 43 forming an outermost surface of the back sheet 40.

The PTFE film layer has properties such as heat resistance, chemical resistance, and non-viscosity, allowing the solar cell module to have a stable structure.

A thickness of the polytetrafluoroethylene (PTFE) film ranges from 10 µm to 250 µm. If the thickness of the PTFE film layer is less than 10 *µ*m the thickness is too thin to obtain an effect such as mechanical properties, or the like, and if the thickness of the PTFE film layer exceeds 250 *µ*m, flexibility of the back sheet 40 may be degraded and cost increases, and thus, the thickness of the PTFE film layer ranges from 10 *µ*m 250 *µ*m.

Meanwhile, the surface layer 41 or the PTFE film layer 45 may be bonded to the substrate 43 through thermal bonding, coating, or an adhesive, and an adhesive used herein may include an acrylic resin, an urethane-based resin, an epoxy-based resin.

### [Embodiment]

The related art back sheet 4 and the back sheet 40 according to an embodiment of the present invention were heated at a temperature of 150°C for 30 minutes and contraction percentages of the related art back sheet 4 and the back sheet 40 according to an embodiment of the present invention in a horizontal direction and in a vertical direction were measured.

**[Table 1]**

| | Configuration of back sheet | Contraction percentage in horizontal direction | Contraction percentage in vertical direction |
|---|---|---|---|
| Comparative Example | PVF/PET/PVF | 1.2% | 1.0% |
| Embodiment | PE/PET/PTFE | 0.5% | 0.4% |

As illustrated in Table 1, the back sheet 4 used for the related art solar cell module was formed by bonding polyvinylfluoride (PVF) film layer to upper and lower surfaces of the base substrate 4b, and the back sheet 40 according to an embodiment of the present invention was formed by bonding the polyethylene (PE) film layer 41 to an upper surface of the substrate layer 43 and the polytetrafluoroethylene (PTFE) film layer 45 to a lower surface of the substrate layer 43, and contraction percentages of the back sheet 40 of the comparative example and the back sheet 40 according to an embodiment of the present invention in both a horizontal direction and a vertical direction were measured. It can be noted that the contraction percentages of the back sheet 40 according to an embodiment of the present invention in the horizontal direction and vertical direction were significantly lower.

As can be seen from the foregoing experiment, in the case of the related art, when the solar cell module is used for a long period of time, the back sheet 4 contracts to cause the solar cell module to be deformed in an outer shape, reduce adhesion between the encapsulant 2 and the back sheet 4, and drastically degrade structural stability of the solar cell module. In contrast, in the case of the present invention, since the back sheet 40 is formed of polytetrafluoroethylene (PTFE), even though the solar cell module is used for a long period of time, contraction of the back sheet 40 is prevented and adhesion between the encapsulant 20 and the back sheet 40 is strengthened.

In addition, since the adhesion between the encapsulant 20 and the back sheet 40 is strengthened, separation between the encapsulant 20 and the back sheet 40 is prevented, allowing the solar cell module to have a more stable structure.

The foregoing embodiments and advantages are merely exemplary and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims.

## Claims

1. A solar cell module producing energy using the sunlight, wherein the solar cell module comprises:
a transparent member (10);
an encapsulant (20) allowing the transparent member to be bonded to an upper surface thereof;
a plurality of solar cells (30) fixed within the encapsulant (20); and
a back sheet (40) bonded to a lower surface of the encapsulant (20),
wherein the back sheet comprises:
a substrate (43);
a polytetrafluoroethylene film layer (45) formed on a lower surface of the substrate (43), and having a thickness ranging from 10µm to 250 µm; **characterized by** a surface layer (41) formed on an upper surface of the substrate (43), formed of polyethylene, having a thickness ranging from 5µm to 30µm, and containing a white inorganic substance to enhance tensile strength and dimensional stability of the back sheet (40) and to reflect light of the sun incident onto the back sheet (40) toward the solar cell (30) to increase an amount of light received by the solar cell (30), wherein the surface layer (41) is disposed between the encapsulant (20) and the substrate (43).

2. The solar cell module of claim 1, wherein the encapsulant (20) is formed as a polyolefin-based encapsulant.

3. The solar cell module of claim 1, wherein the encapsulant (20) includes an ethylene vinyl acetate-based encapsulant (21) provided to cover upper portions of the plurality of solar cells (30), and a polyolefin-based encapsulant (23) provided to cover lower portions of the plurality of solar cells (30), and the surface layer (41) is bonded to the polyolefin-based encapsulant.

4. The solar cell module of claim 2 or 3, wherein the substrate (43) is a polyethyleneterephthalate film layer.

## Patentansprüche

1. Solarzellenmodul, das unter Verwendung des Sonnenlichts Energie erzeugt, das Solarzellenmodul umfassend:
ein transparentes Element (10);
eine Einkapselung (20), die es dem transparenten Element ermöglicht, an eine obere Oberfläche davon gebunden zu werden;
eine Vielzahl von Solarzellen (30), die in der Einkapselung (20) befestigt sind; und
eine Rückwand (40), die an eine untere Oberfläche des Einkapselungsmittels (20) gebunden ist, wobei die Rückwand umfasst:
ein Substrat (43);
eine Polytetrafluorethylen-Filmschicht (45), die auf einer unteren Oberfläche des Substrats (43) ausgebildet ist und eine Dicke im Bereich von 10 µm bis 250 µm aufweist; **gekennzeichnet durch**
eine Oberflächenschicht (41), die auf einer Oberseite des Substrats (43) gebildet ist, die aus Polyethylen gebildet ist, eine Dicke im Bereich von 5 µm bis 30 µm aufweist und eine weiße anorganische Substanz enthält, um die Zugfestigkeit und Dimensionsstabilität der Rückwand (40) zu erhöhen und das auf die Rückwand (40) einfallende Licht der Sonne in Richtung der Solarzelle (30) zu reflektieren, um eine von der Solarzelle (30) aufgenommene Lichtmenge zu erhöhen, wobei die Oberflächenschicht (41) zwischen der Einkapselung (20) und dem Substrat (43) angeordnet ist.

2. Solarzellenmodul nach Anspruch 1, wobei die Einkapselung (20) als eine Einkapselung auf Polyolefinbasis ausgebildet ist.

3. Solarzellenmodul nach Anspruch 1, wobei die Einkapselung (20) eine Einkapselung (21) auf EthylenVinylacetat-Basis umfasst, die vorgesehen ist, um obere Abschnitte der Vielzahl von Solarzellen (30) abzudecken, und eine Einkapselung (23) auf Polyolefin-Basis vorgesehen ist, um untere Teile der Vielzahl von Solarzellen (30) zu bedecken, und die Oberflächenschicht (41) an die Einkapselung auf Polyolefinbasis gebunden ist.

4. Solarzellenmodul nach Anspruch 2 oder 3, wobei das Substrat (43) eine Polyethylenterephthalat-Filmschicht ist.

## Revendications

1. Module de cellule solaire produisant de l'énergie à l'aide de la lumière du soleil, dans lequel le module de cellule solaire comprend :
un élément transparent (10) ;
un encapsulant (20) permettant à l'élément transparent d'être lié à une surface supérieure de celui-ci ;
une pluralité de cellules solaires (30) fixées dans l'encapsulant (20) ; et
une feuille de renfort (40) liée à une surface inférieure de l'encapsulant (20),
dans lequel la feuille de renfort comprend :
un substrat (43) ;
une couche de film de polytétrafluoroéthylène (45) formée sur une surface inférieure du substrat (43) et ayant une épaisseur de 10 µm à 250 µm ;
**caractérisé par**
une couche de surface (41) formée sur une surface supérieure du substrat (43), formée de polyéthylène, ayant une épaisseur dans la plage de 5 µm à 30 µm, et contenant une substance inorganique blanche pour renforcer la résistance à la traction et la stabilité dimensionnelle de la feuille de renfort (40) et pour réfléchir la lumière du soleil incidente sur la feuille de renfort (40) vers la cellule solaire (30) afin d'augmenter une quantité de lumière reçue par la cellule solaire (30), dans lequel la couche de surface (41) est disposée entre l'encapsulant (20) et le substrat (43).

2. Module de cellule solaire selon la revendication 1, dans lequel l'encapsulant (20) est formé sous la forme d'un encapsulant à base de polyoléfine.

3. Module de cellule solaire selon la revendication 1, dans lequel l'encapsulant (20) comprend un encapsulant à base d'éthylène-acétate de vinyle (21) prévu pour couvrir des parties supérieures de la pluralité de cellules solaires (30), et un encapsulant à base de polyoléfine (23) prévu pour couvrir des parties inférieures de la pluralité de cellules solaires (30), et la couche de surface (41) est liée à l'encapsulant à base de polyoléfine.

4. Module de cellule solaire selon la revendication 2 ou 3, dans lequel le substrat (43) est une couche de film de polytéréphtalate d'éthylène.
